# EUROPEAN PATENT APPLICATION

(11) **EP 4 664 629 A1**
(43) Date of publication of application: **17.12.2025**
(21) Application number: 25176343.9
(22) Date of filing: 14.05.2025
(51) Int. Cl.: H01M 50/204, H01M 50/271, H01M 50/287, H01M 50/296, H01M 50/569, H01M 50/583

(54) **BATTERY WITH BUSBAR CONNECTION BETWEEN CELL PACK AND COMPONENTS IN LID**

(30) Priority: 03.06.2024 US 202418731621
(71) Applicant: Navico Group Americas LLC, Menomonee Falls, WI 53051 (US)
(72) Inventor: BOTS, Harrie, 3027GS Rotterdam (NL); WILLEMS, Maarten, 1151ER Waterland (NL); HAISMA, Arjen, 1055TC Amsterdam (NL)
(74) Representative: Gill Jennings & Every LLP

(57) **Abstract**

A battery (10) has a housing (20), a cell pack (30) supported within the housing (20), and a lid (40) configured to close an open end (21) of the housing (20). A first terminal (71) is supported by the lid (40). A first busbar (61) is configured to electrically couple the cell pack (30) to the first terminal (71). A first electrical component (83, 84, 102) is supported by the lid (40) and electrically coupled between the first busbar (61) and the first terminal (71).

## Description

### FIELD

The present disclosure relates to batteries, and more specifically to batteries comprising a plurality of cells forming a battery pack.

### BACKGROUND

Batteries may be formed from multiple cells together forming a pack (or "cell pack"). Often, the pack is contained within a housing, with terminals accessible from outside the housing for connecting the battery to a load. The battery is often provided with a battery management system (BMS) for monitoring the cells, which BMS may be located within the housing.

### SUMMARY

This Summary is provided to introduce a selection of concepts that are further described below in the Detailed Description. This Summary is not intended to identify key or essential features of the claimed subject matter, nor is it intended to be used as an aid in limiting the scope of the claimed subject matter.

In accordance with some embodiments of the disclosed subject matter, a battery comprises a housing, a cell pack supported within the housing, and a lid configured to close an open end of the housing. A first terminal is supported by the lid. A first busbar is configured to electrically couple the cell pack to the first terminal. A first electrical component is supported by the lid and electrically coupled between the first busbar and the first terminal.

In some embodiments, a second terminal is supported by the lid. A second busbar is configured to electrically couple the cell pack to the second terminal. A second electrical component is supported by the lid and electrically coupled between the second busbar and the second terminal.

In some embodiments, the first and second electrical components are each selected from a battery protection switch and a fuse.

In some embodiments, each of the first and second busbars has a first segment comprising a first end of the busbar that is coupled to the cell pack and a second segment comprising an opposite second end of the busbar that is coupled to the lid. A major axis of the first segment of each busbar is not coplanar with a major axis of the second segment of each busbar.

In some embodiments, the first end of each busbar is closer to the open end of the housing than is the second end of each busbar, and the second end of each busbar is located outside of the housing.

In some embodiments, the battery further comprises fasteners that couple the respective second ends of the first and second busbars to an inner side of the lid, and the fasteners are accessible from an outer side of the lid.

In some embodiments, the first and second busbars have a sloped and/or stepped shape.

In some embodiments, the first electrical component is coupled to an inner side of the lid and removable from the housing simultaneously with the lid. The first busbar remains coupled to the cell pack and the housing when the first electrical component and the lid are removed from the housing.

In some embodiments, the battery further comprises a printed circuit board (PCB) that is connected to the lid and removable from the housing simultaneously with the lid.

In some embodiments, the only wired connections extending from the housing to the lid are selected from a wired connection from a sensor located in the housing to the PCB, and a wired connection from a heat pad located in the housing to the PCB.

In some embodiments, no cabled or wired connections are provided between the cell pack and the first terminal.

In accordance with some embodiments of the disclosed subject matter, a battery comprises a housing, a cell pack supported within the housing, and a lid configured to close an open end of the housing. A printed circuit board (PCB) is connected to the lid and removable from the housing simultaneously with the lid. A busbar is configured to electrically couple the cell pack to components on the PCB. The busbar remains connected to the cell pack when the PCB and the lid are removed from the housing.

In some embodiments, the busbar has a first segment comprising a first end of the busbar that is coupled to the cell pack and a second segment comprising an opposite second end of the busbar that is coupled to the lid. A major axis of the first segment of the busbar is not coplanar with a major axis of the second segment of the busbar.

In some embodiments, the first end of the busbar is closer to the open end of the housing than is the second end of the busbar, and the second end of the busbar is located outside of the housing.

In some embodiments, the battery further comprises a fastener that couples the second end of the busbar to an inner side of the lid, and the fastener is accessible from an outer side of the lid.

In some embodiments, the battery further comprises a terminal supported by the lid, and the busbar is configured to electrically couple the cell pack to the terminal.

In some embodiments, the busbar has a sloped and/or stepped shape.

In some embodiments, the PCB supports components of a battery protection switch.

In some embodiments, the PCB is a first PCB and the busbar is a first busbar, and the battery further comprises a second PCB connected to the lid and removable from the housing simultaneously with the lid. The first PCB supports components of a battery protection switch and the second PCB supports components of a battery management system.

In some embodiments, the busbar is a first busbar and the battery further comprises a second busbar that remains connected to the cell pack when the lid is removed from the housing. First and second terminals are supported by the lid. The first busbar is configured to electrically couple the cell pack to the first terminal and the second busbar is configured to electrically couple the cell pack to the second terminal.

### BRIEF DESCRIPTION OF THE DRAWINGS

The present disclosure is described with reference to the following Figures. The same numbers are used throughout the Figures to reference like features and like components.
FIG. 1 is an exploded view of a battery according to the present disclosure.
FIG. 2 shows a cell pack of the battery prior to installation in a housing.
FIG. 3 shows the cell pack installed in a housing.
FIG. 4 is a close-up view of the area denoted in FIG. 3.
FIG. 5 shows an inner side of a lid of the battery, with a number of components installed within the lid.
FIG. 6 shows a number of electrical components that are to be located within the lid, connected to electrical components that are to be installed on the cell pack.
FIG. 7 is a cross section of the assembled battery.
FIG. 8 is a close-up view of the lefthand side of the view in FIG. 7.
FIG. 9 is a close-up view of the righthand side of the view in FIG. 7.
FIG. 10 shows a busbar of the battery in isolation.
FIG. 11 is a schematic of the battery connected to a load.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items.

Unless otherwise specified or limited, the phrases "at least one of A, B, and C," "one or more of A, B, and C," and the like, are meant to indicate A, or B, or C, or any combination of A, B, and/or C, including combinations with multiple instances of A, B, and/or C. Likewise, unless otherwise specified or limited, the terms "mounted," "connected," "linked," "supported," and "coupled" and variations thereof are used broadly and encompass both direct and indirect mountings, connections, supports, and couplings. Further, unless otherwise specified or limited, "connected" and "coupled" are not restricted to physical or mechanical connections or couplings and may include electrical connections and/or couplings.

As used herein, unless otherwise limited or defined, discussion of particular directions is provided by example only, with regard to particular embodiments or relevant illustrations. For example, discussion of "top," "bottom," "front," "back," "left," "right," "lateral" or "longitudinal" features is generally intended as a description only of the orientation of such features relative to a reference frame of a particular example or illustration. Correspondingly, for example, a "top" feature may sometimes be disposed below a "bottom" feature (and so on), in some arrangements or embodiments. Additionally, use of the words "first," "second", "third," etc. is not intended to connote priority or importance, but merely to distinguish one of several similar elements from another.

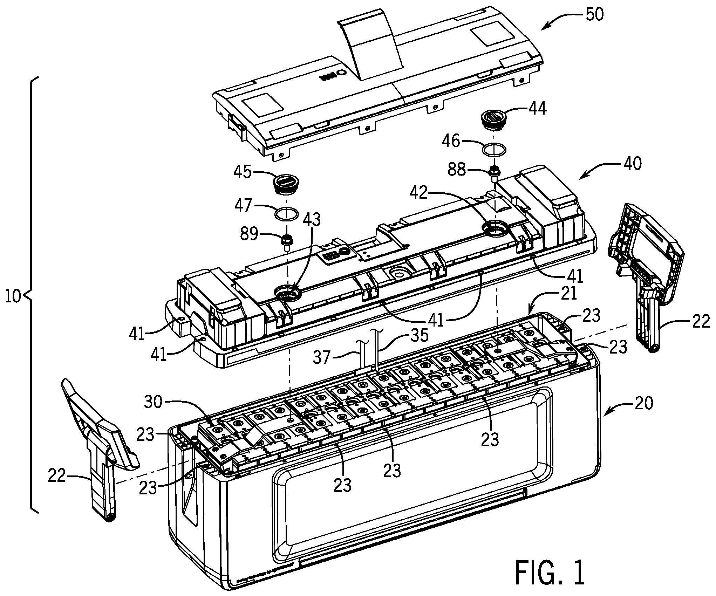

FIG. 1 is an exploded view of a battery 10 according to the present disclosure. The battery 10 comprises a housing 20, a cell pack 30 supported within the housing 20, and a lid 40 configured to close an open end 21 of the housing 20. In the orientation shown here, the open end 21 of the housing 20 is the upper end thereof; however, the open end could conceivably be one of the sides of the housing 20 or a combination of the upper end and one or more of the sides. The housing 20 further includes a pair of handles 22, one at each end thereof, which can be used to carry the battery 10. The lid 40 is configured to be attached to the housing 20 over the open end 21 thereof by way of fasteners (not shown) that extend through holes 41 in the lid 40 and corresponding holes 23 in the housing 20. A cover 50 is connected to the lid 40, also by way of fasteners (not shown), for purposes described hereinbelow.

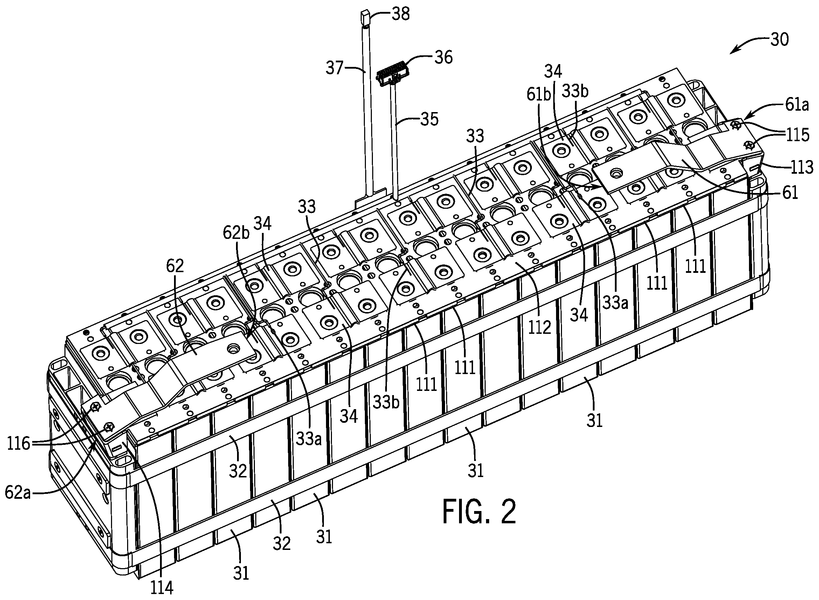

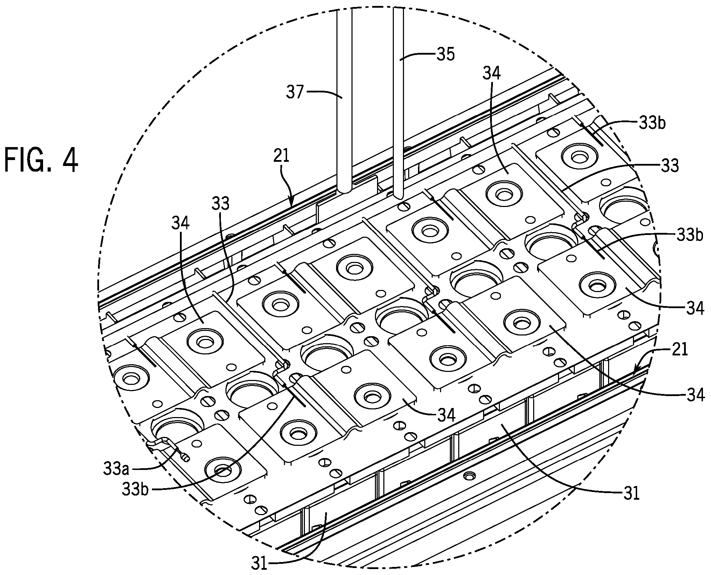

FIG. 2 shows the cell pack 30 removed from the housing 20. The cell pack 30 includes a plurality of cells 31 held together by bands 32. Each cell 31 may be a Lithium-Iron Phosphate (LiFePO4) cell, although other types of battery cells are contemplated. In the present embodiment, sixteen prismatic cells are provided, although fewer or more cells and/or different shapes of cells could be provided in different embodiments. Further, although the cells 31 are not aggregated into modules, in other embodiments, they may be so combined. Several strips or a sheet of foam 111 separate(s) the upper sides of the cells 31 from a layer of adhesive 112, on top of which busbars 34 are situated to electrically connect neighboring cells to one another in series. Referring briefly also to FIG. 4, wires 33 are connected to each cell 31 by way of the busbars 34, which wires 33 are for relaying information related to temperature and voltage of the cells 31. In one example, some of the wires 33 are connected to temperature sensors 33a (e.g., NTC thermistors) for sensing temperature of the cells. Other wires 33 have ends 33b between which voltage drop is measured. The voltage and temperature sense wires 33 can be maintained in place by the layer of adhesive 112 until they are soldered to the busbars 34. The voltage and temperature sense wires 33 are aggregated into a single cable 35 that extends from the cell pack 30 and terminates in a connector 36. A heating pad (not shown) is located on the opposite side of the cell pack 30 from that shown here, between the cells 31 and bands similar to those shown at 32. A cable 37 extends from the heating pad and terminates in a connector 38.

Still referring to FIG. 2, first and second busbars 61, 62 are electrically connected in series with the cells 31, such that electrical energy is configured to flow from one of the first and second busbars 61, 62, through each cell 31 in the cell pack 30, and then through the other of the first and second busbars 61, 62 when the battery 10 is connected to a load. As will be discussed further below, the first and second busbars 61, 62 are the main electrical connections between the cells 31 in the cell pack 30 and terminals of the battery 10 to which a user is to connect a device to be powered by the battery 10.

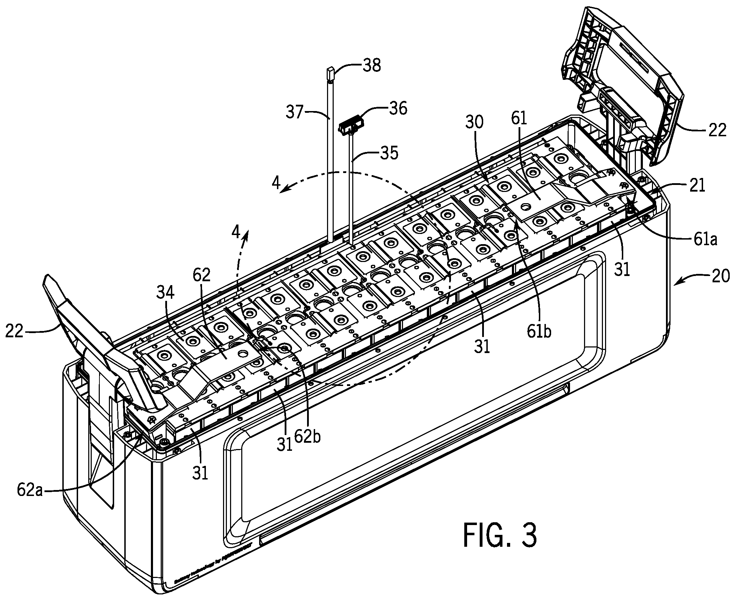

FIG. 3 shows the cell pack 30 supported within the housing 20, while FIG. 4 shows a close-up of the area noted in FIG. 3. It can be seen that a majority (90% or more) of the cell pack 30 is located within the housing 20 "below" the plane in which the open end 21 of the housing 20 is defined. The upper ends of the cells 31, the busbars 34, and the wires 33 are located "above" the plane of the open end 21. In other examples, the upper ends of the cells 31 and the busbars 34 and wires 33 are located even with or below the plane of the open end 21 of the housing 20. The first and second busbars 61, 62 each have first ends 61a, 62a coupled to the cell pack 30 and opposite second ends 61b, 62b configured to be coupled to the lid 40. As shown in FIG. 2, the first end 61a of first busbar 61 is supported by block 113 and fastened thereto by way of fasteners 115, and the first end 62a of second busbar 62 is supported by block 114 and fastened thereto by way of fasteners 116. The coupling of the second ends 61b, 62b of the busbars 61, 62 to the lid 40 will be described below.

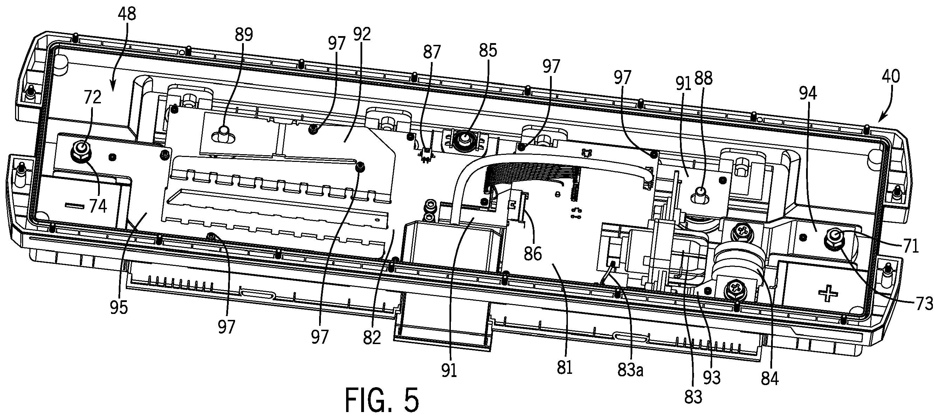

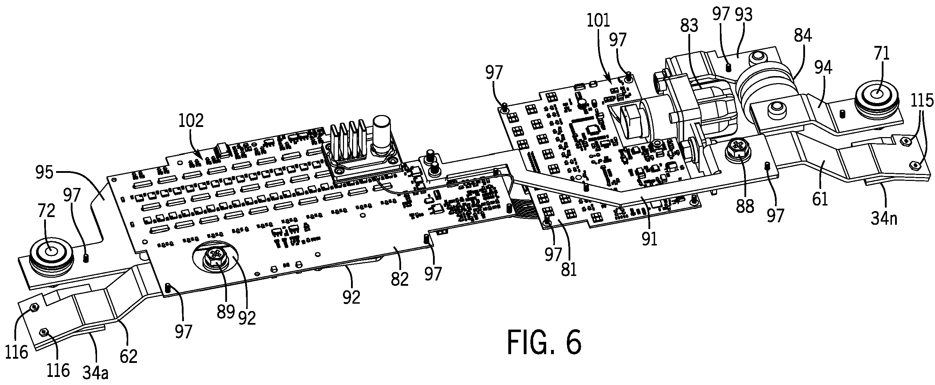

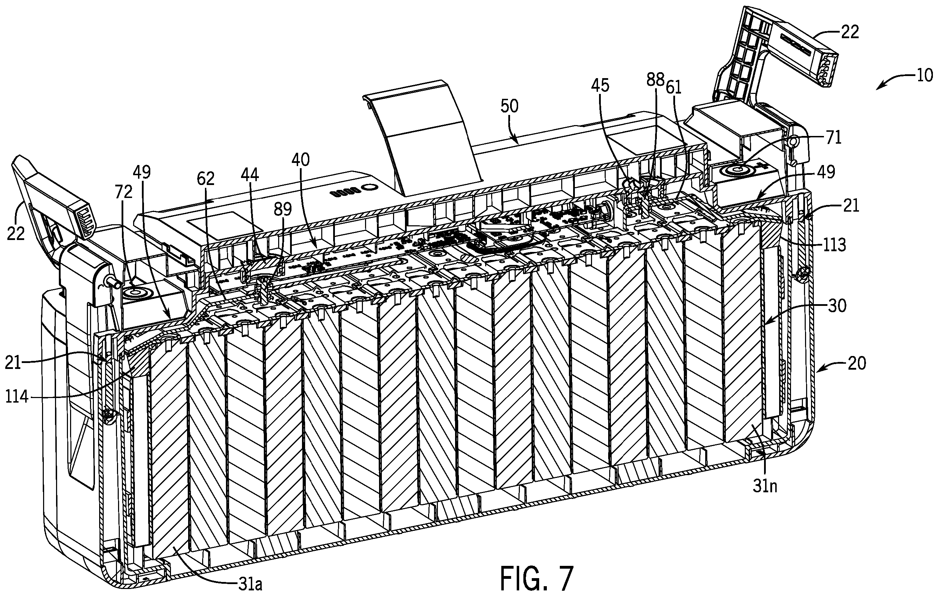

FIG. 5 shows an inner side 48 of the lid 40 and a variety of electrical components supported thereby. For example, a first terminal 71 and a second terminal 72, to which a user is to connect a load, are both supported by the lid 40. The lower ends of the terminals 71, 72 are shown in FIG. 5, while their respective upper ends are shown in FIGS. 6 and 7. The first and second terminals 71, 72 are supported by the lid 40 in that they extend through apertures (not shown, but which extend through recessed areas 49, FIG. 7) in the lid 40. Each terminal 71, 72 has an upper end (FIGS. 6 and 7) that is too large in diameter to fit through the respective aperture in the lid 40, and a lesser diameter lower end (FIG. 5) which, once inserted through the aperture, is secured to a respective busbar 94, 95 by a respective nut 73, 74.

Further electrical components are supported on the inner side 48 of the lid 40 as shown in FIG. 5. For example, two printed circuit boards (PCBs) 81, 82 are supported by the lid 40, such as by way of fasteners 97 inserted through the PCBs and into bosses (not shown) formed in the inner side 48 of the lid 40. The PCBs 81, 82 could additionally or alternatively be supported by the lid 40 using adhesive, slots, clips, and/or other known connection means.

Referring now also to FIG. 6, which shows the PCBs 81, 82 and other electrical components from above, PCB 81 supports components of a battery management system (BMS) 101, while PCB 82 supports components of a battery protection switch (BPS) 102.

Those having ordinary skill in the relevant art would understand that the BMS 101 is a control module that includes a microprocessor, memory, communication interface(s), integrated circuits, and semiconductors such as rectifiers and transistors, for example including MOSFETs. Together, these components enable the BMS 101 to provide protection for the cells 31 from overcharging, over-discharging, over-current, over-temperature, and under-temperature, as well as to provide features such as cell balancing and/or charging. To perform such functions, the BMS 101 monitors voltage, temperature, current, and state of charge and/or health, among other states of the cells 31. Thus, the BMS 101 is provided with information from temperature sensors 33a, voltage sensors 33b, and current sensors (not shown) associated with the cells 31, as is known in the art. For this purpose, a port 86 (FIG. 5) is provided on the PCB 81 for receiving the connector 36 on the end of the voltage/temperature sense cable 35 so as to provide voltage and temperature information to the BMS 101. This same cable 35 also provides current from the cell pack 30 to the BMS 101 to power the BMS 101. The BMS 101 shown here is a centralized BMS, with a single controller connected to each cell 31. Although it is a single module shown on a single PCB 81 in the present example, in other examples, the BMS 101 can be provided on one or more circuit boards.

The battery protection switch 102 (also sometimes referred to by those skilled in the art as a battery protection system, a battery protection unit, an electronic disconnect switch, or a cutoff switch) comprises a combination of electrical components such as a current shunt resistor, heat sink, integrated circuits and semiconductors such as gate drivers and MOSFETs. The battery protection switch 102 is configured to disconnect the cell pack 30 from the terminals 71, 72 under certain conditions in order to prevent thermal runaway or death of the cell.

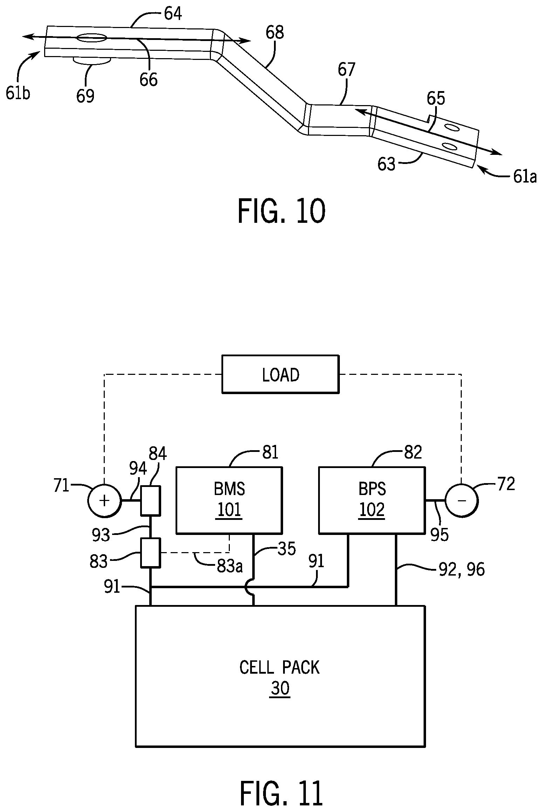

A pyro fuse 83 and fuse 84 are also supported by the lid 40. Under certain conditions, such as when the battery 10 malfunctions, the BMS 101 is configured to provide an ignition current to the pyro fuse 83 by way of wire 83a (see FIGS. 5 and 11), which actuates the pyro fuse 83 to prevent the flow of current therethrough. The pyro fuse 83 is configured to be activated in the event that the battery protection switch 102 opens, but a current is still detected (e.g., because the MOSFETs are damaged). The fuse 84 acts as a second layer of protection against between the cell pack 30 and the load. A gas valve 85 is also supported by the lid 40, which the BMS 101 is configured to open under certain conditions to allow gas to escape from the housing 20. A port 87 is provided on the PCB 82 for receiving the connector 38 on the end of the heating pad cable 37. Each of these electrical components is supported by the lid 40 by way of the PCBs 81, 82 and/or by way of additional fasteners, adhesives, slots, and/or clips, either directly or by way of connection to busbars 91, 93, 94, 95, etc. which are in turn fastened to the inner side 48 of the lid 40 by fasteners 97. Thus, all of the components shown in FIG. 5 are attached directly or indirectly to the lid 40 and are removable from the housing 20 simultaneously/together with the lid 40.

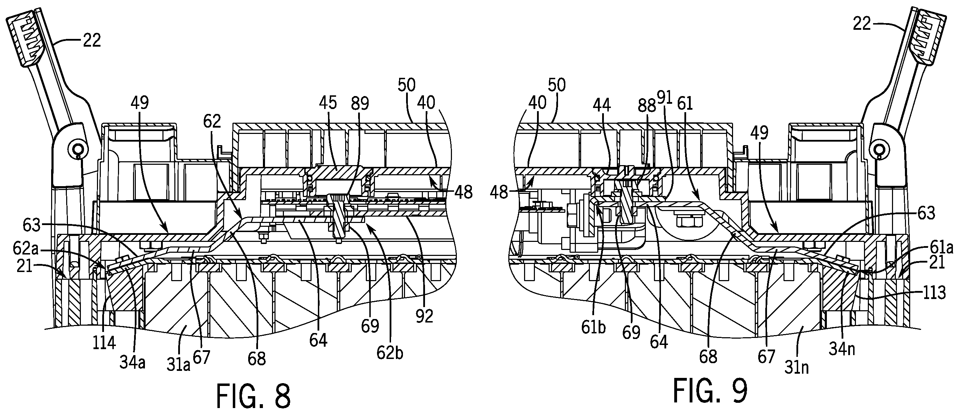

FIG. 7 shows a cross-section of the assembled battery 10 (i.e., with the lid 40 connected to the housing 20), while FIGS. 8 and 9 show close-up views at both ends thereof. It can be seen that each of the first and second busbars 61, 62 has a first segment 63 comprising the first end 61a, 62a of the busbar 61, 62 that is coupled to the cell pack 30. Each of the first and second busbars 61, 62 also has a second segment 64 comprising the opposite second end 61b, 62b of the busbar 61, 62 that is coupled to the lid 40. The first ends 61a, 62a of the busbars 61, 62 are coupled to the cell pack 30 at respective blocks 113, 114 as noted hereinabove. The second ends 61b, 62b of busbars 61, 62 are coupled to the lid 40 by fasteners and further busbars, as will be described below. The first end 61a, 62a of each busbar 61, 62 is closer to the open end 21 of the housing 20 than is the second end 61b, 62b of each busbar 61, 62. The second end 61b, 62b of each busbar 61, 62 is located outside of the housing 20. In the orientation shown here, "outside of" means above the plane of the open end 21 of the housing 20, but in different orientations, "outside of" would mean anything that does not fall on the housing side of the plane of the open end 21. That is, in the orientation of the drawings, when the assembly is viewed in plan, the second end 61b, 62b of each busbar 61, 62 appears to be within the perimeter of the housing 20, but when viewed in elevation, the second end 61b, 62b of each busbar 61, 62 is located above the plane of the open end 21. In contrast, the first end 61a, 62a of each busbar 61, 62 may be below, level with, or immediately above the plane of the open end 21 of the housing 20.

Referring to FIGS. 1 and 6-9 together, fasteners 88, 89 are provided to couple the respective second ends 61b, 62b of the first and second busbars 61, 62 to the inner side 48 of the lid 40. The fasteners 88, 89 are aligned with apertures 42, 43 (FIG. 1) in the lid 40 and thus have heads that are accessible from an outer side of the lid 40. The fasteners 88, 89 connect the second ends 61b, 62b of the busbars 61, 62 to further busbars 91, 92, respectively. The first busbar 61 connects to the further busbar 91 at fastener 88, while the second busbar 62 connects to the further busbar 92 at fastener 89. The further busbars 91, 92 are directly or indirectly connected to the lid 40 by way of further fasteners 97, the PCBs 81, 82, and/or other electrical components. In this way, the second ends 61b, 62b of the first and second busbars 61, 62 are coupled to electrical components that are supported by the lid 40, and therefore themselves are coupled to the inner side 48 of the lid 40. Each fastener 88, 89 is tightened within a screw boss 69 formed in each busbar 61, 62 (see also FIG. 10) so as to connect the busbars 61, 62 to the busbars 91, 92, respectively. After tightening, each fastener 88, 89 is covered with a cap 44, 45 that plugs the respective aperture 42, 43 in the lid 40, each of which cap 44, 45 may be provided with a respective O-ring 46, 47 to prevent water intrusion. The cover 50 may be closed over the central portion of the lid 40 to provide the apertures 42, 43 with additional protection from the elements.

Referring to FIGS. 5-9, it will now be described how the first busbar 61 is configured to electrically couple the cell pack 30 to the first terminal 71 and the second busbar 62 is configured to electrically couple the cell pack 30 to the second terminal 72. In the example shown here, the first terminal 71 is a positive terminal and the second terminal 72 is a negative terminal. The last cell 31n in the series of cells 31 is electrically connected to the first end 61a of the first busbar 61 by way of busbar 34n, which is supported on block 113. The second end 61b of the first busbar 61 is electrically connected to the busbar 91, which is in turn electrically connected to the pyro fuse 83. The pyro fuse 83 is electrically connected to the fuse 84 by way of busbar 93, and a further busbar 94 electrically connects the fuse 84 to the first terminal 71. A load can be connected between the first terminal 71 and the second terminal 72. The second terminal 72 is electrically connected by way of busbar 95 to electrical components (e.g., shunt, MOSFETs, etc.) on PCB 82, which are in turn electrically connected to busbar 92. Busbar 92 is connected to second busbar 62 by way of fastener 89, and busbar 62 is in turn connected to the first cell 31a in the series of cells 31 by way of busbar 34a, which is supported by block 114. Thus, when a load is connected across the terminals 71, 72, a circuit is completed from cell 31n, through first busbar 61, pyro fuse 83, fuse 84, first terminal 71, the load, second terminal 72, battery protection switch 102 supported on PCB 82, through second busbar 62, to cell 31a. This is shown by the circuit diagram in FIG. 11.

As mentioned hereinabove, all the electrical components shown in FIG. 5 are supported by the lid 40, on the inner side 48 (here, the underside) thereof, including the PCB 81 that supports components of the BMS 101, pyro fuse 83, fuse 84, first terminal 71, the PCB 82 that supports components of the battery protection switch 102, and second terminal 72. According to the present disclosure, a first electrical component (e.g., pyro fuse 83, fuse 84) is supported by the lid 40 and electrically coupled between the first busbar 61 and the first terminal 71. A second electrical component (e.g., one or more components of the battery protection switch 102) is supported by the lid 40 and electrically coupled between the second busbar 62 and the second terminal 72. The first and second electrical components are each selected from a battery protection switch (e.g., one or more components on PCB 82) and a fuse (e.g., pyro fuse 83, fuse 84). The first electrical component (e.g., pyro fuse 83, fuse 84) is coupled to the inner side 48 of the lid 40, such as by way of fasteners 97 and busbars 91, 93, 94, and is removable from the housing 20 simultaneously with the lid 40. The second electrical component (e.g., one or more components of the battery protection switch 102) is also coupled to the inner side 48 of the lid 40, such as by way of fasteners 97 and PCB 82, and is removable from the housing 20 simultaneously with the lid 40. The lid 40 can be removed from the housing 20 after removal of fasteners from the holes 23, 41 described above with respect to FIG. 1. As shown in FIG. 3, the first busbar 61 remains coupled to the cell pack 30 and the housing 20 when the first electrical component and the lid 40 are removed from the housing 20. So too does the second busbar 62 remain coupled to the cell pack 30 and the housing 20 when the second electrical component and the lid 40 are removed from the housing 20.

According to the present disclosure, the printed circuit boards (PCBs) 81, 82 are also connected to the lid 40 and removable from the housing 20 simultaneously with the lid 40. As shown in FIGS. 1 and 2, the only wired connections extending from the housing 20 to the lid 40 are selected from (i) a wired connection (provided by cable 35) from a sensor (e.g., temperature sensors 33a and voltage sensors 33b) located in the housing 20 to the PCB 81, and (ii) a wired connection (provided by cable 37) from a heat pad located in the housing 20 to the PCB 82. Note that no cabled or wired connections are provided between the cell pack 30 and the first terminal 71 (nor, for that matter, between the cell pack 30 and the second terminal 72). Rather, electrical connections between the cell pack 30 and the terminals 71, 72 are made by way of busbars 61, 62, further electrical components such as fuses or battery protection switches, and further busbars. The first and second busbars 61, 62 have a sloped and/or stepped shape that allows them to extend from a first plane or level, where their first ends 61a, 62a are aligned with the upper end of the cell pack 30, to a second plane or level, where their second ends 61b, 62b are aligned with further busbars 91, 92 located in the lid 40.

Through research and development, the present inventors realized that it is cumbersome to connect a cell pack to the terminals of a battery when the terminals are supported by the lid. Doing so typically requires running thick cables from the last cells in the cell packs to each of the terminals, which cables must be long enough that the connections to the terminals can be made while the lid is open and the underside of the terminals is accessible for connecting the cables thereto. Before the lid can thereafter be attached to the housing, the cables must be folded, coiled, or otherwise packed under the lid. In contrast, the present inventors have developed an elegant assembly in which the last cells 31a, 31n in the cell pack 30 are connected to the terminals 71, 72 of the battery 10 by way of a series of busbars and other electrical components, many of which are supported on the inner side 48 of the lid 40. Initially, the gap between the cell pack 30 and the components supported by the lid 40 is traversed by way of busbars 61, 62, instead of cumbersome cables. The busbars 61, 62 are connected to the electrical components that are supported by the lid 40 by way of fasteners 88, 89, which are accessible from the outer side of the lid 40 via apertures 42, 43. Thus, high-voltage electrical connections between the cell pack 30 and the terminals 71, 72 can be made after the lid 40 has been placed over the open end 21 of the housing 20, rather than while the lid 40 is adjacent to the housing 20 (which, as noted above, requires thick cabling to achieve). The only wired connections between the housing 20 and the lid 40 (the wired connections provided by cables 35 and 37) are much thinner and more flexible than cables typically used to carry high voltage current from the cell pack to the terminals.

Therefore, the present inventors have developed a battery 10 comprising a housing 20, a cell pack 30 supported within the housing 20, and a lid 40 configured to close an open end 21 of the housing 20. A terminal 71 or 72 is supported by the lid 40, and a busbar 61 or 62 is configured to electrically couple the cell pack 30 to the terminal 71 or 72. An electrical component (e.g., components of battery protection switch 102, pyro fuse 83, fuse 84) is supported by the lid 40 and electrically coupled between the busbar 61 or 62 and the terminal 71 or 72.

According to one example, the battery 10 comprises a PCB 82 connected to the lid 40 and removable from the housing 20 simultaneously with the lid 40. The busbar 62 is configured to electrically couple the cell pack 30 to components (e.g., those of the battery protection switch 102) on the PCB 82. According to the present disclosure, the busbar 62 remains connected to the cell pack 30 when the PCB 82 and the lid 40 are removed from the housing 20. That is, the busbar 62 remains fastened to the busbar 34a on the block 114 at the end of the cell pack 30 upon removal of the lid 40 from the housing 20. In some embodiments, the PCB 82 supports components of a battery protection switch 102.

In some embodiments, the busbar is a first busbar 62 and the battery 10 further comprises a second busbar 61 that remains connected to the cell pack 30 when the lid 40 is removed from the housing 20. First and second terminals 72, 71 are supported by the lid 40. The first busbar 62 is configured to electrically couple the cell pack 30 to the first terminal 72 and the second busbar 61 is configured to electrically couple the cell pack 30 to the second terminal 71. As such, the labeling of the busbars and terminals as "first" and "second" herein is arbitrary.

As noted hereinabove, and specifically with respect to FIGS. 8-10, each busbar 61, 62 has a first segment 63 comprising a first end 61a, 62a of the busbar 61, 62 that is coupled to the cell pack 30 and a second segment 64 comprising an opposite second end 61b, 62b of the busbar 61, 62 that is coupled to the lid 40. Although only first busbar 61 is shown in FIG. 10, busbar 62 is a mirror image of busbar 61 and will therefore not be described separately herein. A major axis 65 of the first segment 63 of the busbar 61 is not coplanar with a major axis 66 of the second segment 64 of the busbar 61. Between the first segment 63 and the second segment 64, the busbar 61 has further segments 67, 68, which have major axes that are not coplanar with either of the major axes 65, 66 of the first and second segments 63, 64. Together, the segments 63, 64, 67, 68 give the busbar 61 a sloped and/or stepped shape, which is configured to allow the busbar 61 to clear the respective end cell 31a, 31n and the lid 40, which is lower in recessed areas 49 in order to accommodate the handles 22 when the handles 22 are collapsed onto the lid 40. The exact shape of the busbars 61, 62 may be varied in order to accommodate different layouts and assemblies.

As shown in FIGS. 8 and 9, the first end 61a, 62a of each busbar 61, 62 is closer to the open end 21 of the housing 20 than is the second end 61b, 62b of each busbar 61, 62. The second end 61b, 62b of each busbar 61, 62 is located outside of the housing 20, i.e., above the plane in which the open end 21 of the housing 20 is defined. Fasteners 88, 89 couple the respective second ends 61b, 62b of each busbar 61, 62 to an inner side 48 of the lid 40. As noted, the fasteners 88, 89 are accessible from an outer side of the lid 40 via apertures 42, 43.

In some embodiments, the PCB is a first PCB 82 and the busbar is a first busbar 62, and the battery 10 further comprises a second PCB 81 connected to the lid 40 and removable from the housing 20 simultaneously with the lid 40. The first PCB 82 supports components of a battery protection switch 102 and the second PCB 81 supports components of a battery management system 101. As such, the labeling of the busbars and PCBs as "first" and "second" herein is arbitrary.

## Claims

1. A battery comprising:
a housing (20);
a cell pack (30) supported within the housing (20);
a lid (40) configured to close an open end (21) of the housing (20);
a first terminal (71) supported by the lid (40);
a first busbar (61) configured to electrically couple the cell pack (30) to the first terminal (71); and
a first electrical component (83, 84, 102) supported by the lid (40) and electrically coupled between the first busbar (61) and the first terminal (71).

2. The battery of claim 1, further comprising:
a second terminal (72) supported by the lid (40);
a second busbar (62) configured to electrically couple the cell pack (30) to the second terminal (72); and
a second electrical component (83, 84, 102) supported by the lid (40) and electrically coupled between the second busbar (62) and the second terminal (72).

3. The battery of claim 2, wherein the first and second electrical components (83, 84, 102) are each selected from a battery protection switch (102) and a fuse (83, 84).

4. The battery of claim 2 or claim 3, wherein each of the first and second busbars (61, 62) has a first segment (63) comprising a first end (61a, 62a) of the busbar that is coupled to the cell pack (30) and a second segment (64) comprising an opposite second end (61b, 62b) of the busbar that is coupled to the lid (40); and
wherein a major axis of the first segment (63) of each busbar (61, 62) is not coplanar with a major axis of the second segment (64) of each busbar (61, 62).

5. The battery of claim 4, wherein the first end (61a, 62a) of each busbar (61, 62) is closer to the open end (21) of the housing (20) than is the second end (61b, 62b) of each busbar (61, 62); and
wherein the second end (61b, 62b) of each busbar (61, 62) is located outside of the housing (20).

6. The battery of claim 4 or claim 5, further comprising fasteners (88, 89) that couple the respective second ends (61b, 62b) of the first and second busbars (61, 62) to an inner side (48) of the lid (40), wherein the fasteners (88, 89) are accessible from an outer side of the lid (40).

7. The battery of any one of claims 4 to 6, wherein the first and second busbars (61, 62) have a sloped and/or stepped shape.

8. The battery of any of the preceding claims, further comprising a printed circuit board (PCB) (81, 82) that is connected to the lid (40) and removable from the housing (20) simultaneously with the lid (40).

9. The battery of claim 8, wherein the only wired connections extending from the housing (20) to the lid (40) are selected from a wired connection (35) from a sensor located in the housing (20) to the PCB, and a wired connection (37) from a heat pad located in the housing (20) to the PCB.

10. The battery of claim 2, further comprising:
a printed circuit board (PCB) (82) connected to the lid (40) and removable from the housing (20) simultaneously with the lid (40);
wherein the second busbar (62) is configured to electrically couple the cell pack (30) to the second electrical component (102) on the PCB (82), and wherein the second busbar (62) remains connected to the cell pack (30) when the PCB (82) and the lid (40) are removed from the housing (20).

11. The battery of claim 10, wherein the PCB (82) supports components of a battery protection switch (102).

12. The battery of claim 10, wherein the PCB (82) is a first PCB, and the battery further comprises:
a second PCB (81) connected to the lid (40) and removable from the housing (20) simultaneously with the lid (40);
wherein the first PCB (82) supports components of a battery protection switch (102) and the second PCB (81) supports components of a battery management system (101).

13. The battery of any one of the preceding claims, wherein the first electrical component (83, 84, 102) is coupled to an inner side (48) of the lid (40) and removable from the housing (20) simultaneously with the lid (40); and
wherein the first busbar (61) remains coupled to the cell pack (30) and the housing (20) when the first electrical component (83, 84, 102) and the lid (40) are removed from the housing (20).

14. The battery of any one of the preceding claims, wherein no cabled or wired connections are provided between the cell pack (30) and the first terminal (71).
